# EUROPÄISCHE PATENTANMELDUNG

(11) **EP 1 320 193 A2**
(43) Veröffentlichungstag der Anmeldung: **18.06.2003**
(21) Anmeldenummer: 02400057.2
(22) Anmeldetag: 12.12.2002
(51) Int. Cl.: H03H 9/64

(54) **Resonatorfilterkaskade**

(30) Priorität: 14.12.2001 DE 10163517
(71) Anmelder: Tele Filter Zweigniederlassung der Dover Germany GmbH, 14513 Teltow (DE)
(72) Erfinder: Martin, Günter, D-01307 Dresden (DE); Wall, Bert, D-14469 Postdam (DE)
(74) Vertreter: Rauschenbach, Dieter, Dipl.-Ing. (FH)

(57) **Zusammenfassung**

Die Erfindung betrifft eine Resonatorfilterkaskade auf der Basis akustischer Oberflächenwellen, bei der mindestens zwei transversal gekoppelte Resonatorfilter, die aus mehreren nebeneinander angeordneten Resonatorstrukturen zusammengesetzt sind und einen Wellenleiter für akustische Oberflächenwellen bilden, und Koppelwandler vorhanden sind.

Der Erfindung liegt die Aufgabe zugrunde, Resonatorfilterkaskaden der bekannten Art so zu verändern, dass die Einfügedämpfung der Filter durch Verringerung der Dämpfung infolge Kaskadierung reduziert wird, ohne eine Koppelspule zu verwenden.

Diese Aufgabe wird durch eine Resonatorfilterkaskade gelöst, bei der die Anzahl der Resonatorstrukturen (21;23;31;33), deren Wandler Koppelwandler (211;231;311;331) sind, in allen transversal gekoppelten Resonatorfiltern (2;3) größer als eins ist und die zu ein und demselben transversal gekoppelten Resonatorfilter (2;3) gehörenden Koppelwandler nicht miteinander verschaltet sind. Erfindungsgemäß sind außerdem je zwei Koppelwandler (211;311 bzw. 231;331) verschiedener transversal gekoppelter Resonatorfilter (2;3) über je ein Paar elektrisch leitende Verbindungen miteinander verbunden

Die Erfindung ist beispielsweise bei Bandpassfiltern mit einer relativen Bandbreite in der Größenordnung von 0,1 % sowie bei Oszillatoren anwendbar.

## Beschreibung

Die Erfindung bezieht sich auf das Gebiet Elektrotechnik/Elektronik. Objekte, bei denen die Anwendung möglich und zweckmäßig ist, sind Bauelemente auf der Basis akustischer Oberflächenwellen wie Bandpassfilter mit einer relativen Bandbreite in der Größenordnung von 0,1 Prozent sowie Oszillatoren.

Es sind Resonatorfilterkaskaden bekannt, bei denen mindestens zwei transversal gekoppelte Resonatorfilter, die aus mehreren nebeneinander angeordneten Resonatorstrukturen zusammengesetzt sind und einen Wellenleiter für akustische Oberflächenwellen bilden, so miteinander verbunden sind, dass jedes der beiden transversal gekoppelten Resonatorfilter Wandler enthält, bestehend aus Sammelelektroden und Zinken und bezeichnet als Koppelwandler, die über elektrisch leitende Verbindungen mit einem Koppelwandler eines jeweils anderen transversal gekoppelten Resonatorfilters verbunden sind, wobei diejenigen Wandler, die keine Koppelwandler sind, bei einem der transversal gekoppelten Resonatorfilter - gegebenenfalls als Parallelschaltung - den Eingangswandler und beim jeweils anderen transversal gekoppelten Resonatorfilter in analoger Weise den Ausgangswandler bilden.

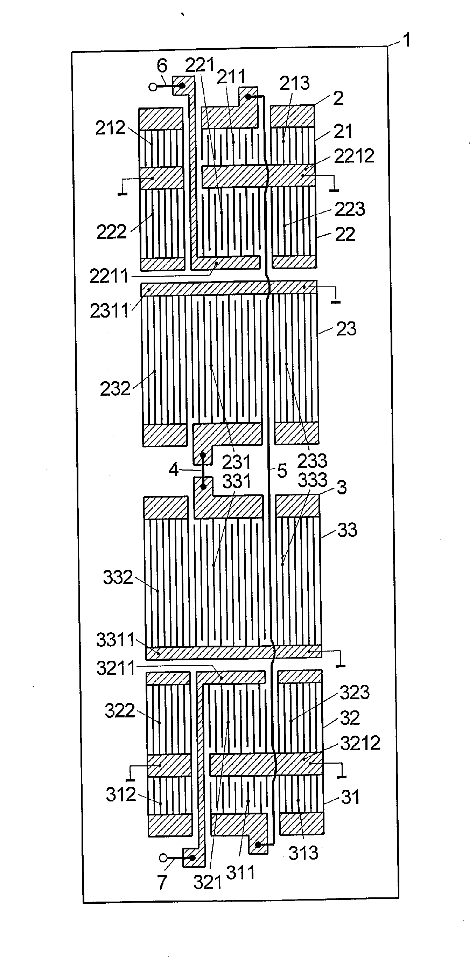

Eine spezielle Ausführungsform (G. Martin, B. Wall, R. Kunze, M. Weihnacht, Proceedings 1993 IEEE Ultrasonics Symposium, S. 35 - 39) enthält vier Wandler, von denen jeweils zwei parallel geschaltet sind. In der Figur 1 dieser Arbeit ist zwar ein unkaskadiertes transversal gekoppeltes Resonatorfilter abgebildet; im Text ist jedoch ausdrücklich die Verwendung solcher transversal gekoppelten Resonatorfilter in einer Filterkaskade erwähnt. Werden in dieser Filterkaskade parallel geschaltete Wandler verschiedener Einzelfilter elektrisch leitend miteinander verbunden, so bedeutet das, dass jeweils zwei Wandler als Parallelschaltung als Koppelwandler betrieben werden.

Bei einer weiteren speziellen Ausführungsform (DE 42 27 362) besteht die Resonatorfilterkaskade aus zwei transversal gekoppelten Resonatorfiltern. Die Koppelwandler verschiedener transversal gekoppelter Resonatorfilter sind über ein Paar elektrisch leitende Verbindungen, Kaskadenverbindung genannt, miteinander verbunden. Zwischen diese Verbindungen ist ein komplexer Koppelwiderstand geschaltet. Im Fall, dass dieser komplexe Koppelwiderstand eine Spule, Koppelspule genannt, ist, wird die infolge der Fehlanpassung der Kaskadenverbindung entstandene Kaskadierungsdämpfung herabgesetzt und demzufolge die Einfügedämpfung der Resonatorfilterkaskade verringert.

Diese Lösung hat den Nachteil, dass die Anwendung von Koppelspulen einen zu hohen Aufwand beim Einsatz von Resonatorfilterkaskaden in elektronischen Schaltungen zur Folge hat.

Der Erfindung liegt die Aufgabe zugrunde, Resonatorfilterkaskaden der bekannten Art so zu verändern, dass die Einfügedämpfung der Filter durch Verringerung der Dämpfung infolge Kaskadierung reduziert wird, ohne eine Koppelspule zu verwenden.

Diese Aufgabe wird durch eine Resonatorfilterkaskade gelöst, bei der die Anzahl der Resonatorstrukturen, deren Wandler Koppelwandler sind, in allen transversal gekoppelten Resonatorfiltern größer als eins ist und die zu ein und demselben transversal gekoppelten Resonatorfilter gehörenden Koppelwandler nicht miteinander verschaltet sind. Erfindungsgemäß sind außerdem je zwei Koppelwandler verschiedener transversal gekoppelter Resonatorfilter über je ein Paar elektrisch leitende Verbindungen miteinander verbunden.

Identische Koppelwandler vorausgesetzt, ist die Fehlanpassung bei Kaskadierung um so kleiner, je größer das Verhältnis des reellen Leitwertes G und des Blindleitwertes 2πf_{R}C des Koppelwandlers an einer Resonanzfrequenz f_{R} ist (C = Kapazität des Koppelwandlers). Bei Resonatorfilterkaskaden mit nur einem Koppelwandler pro transversal gekoppeltem Resonatorfilter kann das Verhältnis G/2πf₀C nur jeweils an einer der Resonanzen, die von den ersten zwei Wellenleitermoden stammen und das Passband bilden, vergrößert werden. Für die jeweils zweite Resonanz wird jedoch das Verhältnis G/2πf₀C verringert, so dass, gemittelt über das Passband, die Fehlanpassung infolge Kaskadierung nur relativ wenig verringert wird.

Im Fall von mehreren Koppelwandlergruppen pro transversal gekoppeltem Resonatorfilter, von denen nur solche Koppelwandler elektrisch leitend miteinander verbunden sind, die zu verschiedenen transversal gekoppelten Resonatorfiltern gehören, ist es möglich, die Fehlanpassung bei Kaskadierung für beide Resonanzen zu verringern, die das Passband bilden.

Nach einer zweckmäßigen Ausgestaltung der Erfindung können diejenigen Resonatorstrukturen, die den Ein- bzw. Ausgang der Resonatorfilterkaskade bilden, jeweils untereinander und auch diejenigen Resonatorstrukturen, die nur Koppelwandler enthalten, jeweils untereinander gleich aufgebaut sind.

Dabei ist es besonders zweckmäßig, wenn stets gleich aufgebaute Koppelwandler verschiedener transversal gekoppelter Resonatorfilter über jeweils ein Paar elektrisch leitender Verbindungen miteinander verbunden sind.

Erfindungsgemäß können in wenigstens einigen Resonatorstrukturen mehrere Koppelwandler vorhanden sein. Diese bilden eine Koppelwandlergruppe, in der die Koppelwandler in Richtung senkrecht zu den Zinken hintereinander angeordnet sind und die gleiche Apertur haben. Dabei ist es besonders zweckmäßig, wenn jede Koppelwandlergruppe zwei Koppelwandler enhält.

Zweckmäßigerweise kann die Anzahl der Koppelwandler jedes transversal gekoppelten Resonatorfilters zwei betragen.

Gemäß einer zweckmäßigen Ausgestaltung enthält jede Resonatorstruktur einen Koppelwandler. Dabei kann die Anzahl der Koppelwandler jedes transversal gekoppelten Resonatorfilters zwei betragen.

Die Summe der Aperturen beider Koppelwandlergruppen pro transversal gekoppeltem Resonatorfilter kann größer sein als die Hälfte der Summe der Aperturen aller Wandler des betreffenden transversal gekoppelten Resonatorfilters, wobei nur ein Aperturwert pro Koppelwandlergruppe in dieser Summe berücksichtigt wird.

Dabei kann bei jedem transversal gekoppelten Resonatorfilter eine der Koppelwandlergruppen unterhalb und die jeweils andere Koppelwandlergruppe oberhalb der senkrecht zu den Zinken verlaufenden Mittellinie des Reflektorstreifen-/Wandlerzinkengebietes angeordnet sein.

Im Fall, dass jede Koppelwandlergruppe zwei Koppelwandler enthält, ist es zweckmäßig, wenn die Zinkenüberlappungslängen in den Koppelwandlergruppen so gewählt sind, dass sie eine Funktion bilden, die in Bezug auf die parallel zu der Zinkenrichtung verlaufenden Mittellinie der Resonatorstrukturen unsymmetrisch ist.

Die erfindungsgemäße Resonatorfilterkaskade kann Teil einer Kaskadenkette sein, wobei mindestens der Eingang oder Ausgang dieser Resonatorfilterkaskade mit dem Ausgang der vorangegangenen bzw. mit dem Eingang der nachfolgenden Resonatorfilterkaskade durch ein Paar elektrisch leitender Verbindungen verbunden ist.

Die Anzahl der transversal gekoppelten Resonatorfilter pro Resonatorfilterkaskade kann zwei betragen.

Besonders zweckmäßig ist es, wenn jeweils eine Komponente aller Paare elektrisch leitender Verbindungen eine gemeinsame Verbindung bilden, wenn diese Komponenten auf gleichem Potenzial liegen.

Zwischen zwei elektrisch leitende Verbindungen, die Koppelwandler von verschiedenen transversal gekoppelten Resonatorfiltern miteinander verbinden, kann ein Blindwiderstand geschaltet sein, falls das Potenzial dieser elektrisch leitenden Verbindungen voneinander verschieden ist.

Nach einer weiteren zweckmäßigen Ausgestaltung der Erfindung können in denjenigen Resonatorstrukturen, deren Wandler den Eingang oder Ausgang der Resonatorfilterkaskade bilden, die Wandler parallel oder in Reihe geschaltet sein, falls die betreffenden Resonatorstrukturen jeweils mehr als einen Wandler enthalten.

Nachstehend ist die Erfindung anhand eines Ausführungsbeispiels und einer zugehörigen Zeichnung näher erläutert.

Auf einem piezoelektrischen Substrat 1 sind zwei identische transversal gekoppelte Resonatorfilter 2 und 3 angeordnet, die aus jeweils drei nebeneinander angeordneten Resonatorstrukturen 21, 22 und 23 bzw. 31, 32 und 33 zusammengesetzt sind. In diesen Resonatorstrukturen schließen in gleicher Reihenfolge die Reflektoren 212 und 213, 222 und 223, 232 und 233, 312 und 313, 322 und 323 sowie 332 und 333 ebene Hohlräume ein, in denen die Wandler 211, 221, 231, 311, 321 und 331 angeordnet sind. Die Wandler 211 und 311, 221 und 321 sowie 231 und 331 sind paarweise identisch aufgebaut.

Die zu verschiedenen transversal gekoppelten Resonatorfiltern gehörenden Wandler 211 und 311 sowie 231 und 331 sind über die elektrisch leitenden Verbindungen 5 bzw. 4 miteinander verbunden. Die jeweils zweite Verbindung zwischen den Wandlern 211 und 311 bzw. 231 und 331 ist über Verbindungen der Sammelelektroden 2212 und 3212 bzw. 2311 und 3311 zum Massepotenzial hergestellt. Demzufolge werden die Wandler 211, 231, 311, und 331 als Koppelwandler betrieben.

Der Wandler 221 ist mit dem Eingang 6 der Resonatorfilterkaskade verbunden und ist deshalb der Eingangswandler der Resonatorfilterkaskade. In analoger Weise ist der Wandler 321 mit dem Ausgang 7 der Resonatorfilterkaskade verbunden und ist deshalb der Ausgangswandler der Resonatorfilterkaskade.

Während die benachbarten Sammelelektroden der Wandler 211 und 221 sowie 311 und 321 auf Grund dessen, dass sie auf gleichem Potenzial liegen, zu einer gemeinsamen Sammelelektrode zusammengefasst sind, sind die benachbarten Sammelelektroden 2211 und 2311 der Wandler 221 und 231 sowie die benachbarten Sammelelektroden 3211 und 3311 der Wandler 321 und 331 voneinander getrennt, weil sie auf unterschiedlichem Potenzial liegen.

## Patentansprüche

1. Resonatorfilterkaskade, bei der mindestens zwei transversal gekoppelte Resonatorfilter (2;3), die aus mehreren nebeneinander angeordneten Resonatorstrukturen (21;22;23 bzw. 31;32;33) zusammengesetzt sind und einen Wellenleiter für akustische Oberflächenwellen bilden, so miteinander verbunden sind, dass jedes der beiden transversal gekoppelten Resonatorfilter (2;3) Wandler enthält, bestehend aus Sammelelektroden und Zinken und bezeichnet als Koppelwandler (211;231 bzw. 311;331), wobei die Koppelwandler (211;231 bzw. 311;331) über elektrisch leitende Verbindungen (4;5) mit einem Koppelwandler (311;331 bzw. 211;231) eines jeweils anderen transversal gekoppelten Resonatorfilters verbunden sind, und wobei diejenigen Wandler (221;321), die keine Koppelwandler sind, bei einem der transversal gekoppelten Resonatorfilter (2) den Eingangswandler und bei einem der anderen transversal gekoppelten Resonatorfilter (3) den Ausgangswandler bilden, **dadurch gekennzeichnet, dass** die Anzahl der Resonatorstrukturen (21;23;31;33), deren Wandler Koppelwandler (211;231;311;331) sind, in allen transversal gekoppelten Resonatorfiltern (2;3) größer als eins ist und die zu ein und demselben transversal gekoppelten Resonatorfilter (2;3) gehörenden Koppelwandler nicht miteinander verschaltet sind, und dass je zwei Koppelwandler (211;311 bzw. 231;331) verschiedener transversal gekoppelter Resonatorfilter (2;3) über je ein Paar elektrisch leitende Verbindungen miteinander verbunden sind.

2. Resonatorfilterkaskade nach Anspruch 1, **dadurch gekennzeichnet, dass** diejenigen Resonatorstrukturen, die den Ein- bzw. Ausgang der Resonatorfilterkaskade bilden, jeweils untereinander und auch diejenigen Resonatorstrukturen, die nur Koppelwandler enthalten, jeweils untereinander gleich aufgebaut sind.

3. Resonatorfilterkaskade nach Anspruch 2, **dadurch gekennzeichnet, dass** stets gleich aufgebaute Koppelwandler (211;311 bzw. 231;331) verschiedener transversal gekoppelter Resonatorfilter (2;3) über jeweils ein Paar elektrisch leitender Verbindungen (4;5) miteinander verbunden sind.

4. Resonatorfilterkaskade nach Anspruch 1, **dadurch gekennzeichnet, dass** in wenigstens einigen Resonatorstrukturen (21;22;23;31;32;33) mehrere Koppelwandler vorhanden sind und diese Koppelwandler eine Koppelwandlergruppe bilden, in der die Koppelwandler in Richtung senkrecht zu den Zinken hintereinander angeordnet sind und die gleiche Apertur haben.

5. Resonatorfilterkaskade nach Anspruch 4, **dadurch gekennzeichnet, dass** jede Koppelwandlergruppe zwei Koppelwandler enthält.

6. Resonatorfilterkaskade nach Anspruch 1, **dadurch gekennzeichnet, dass** jede Resonatorstruktur (21;22;23;31;32;33) einen Koppelwandler (211;311;231;331) enthält.

7. Resonatorfilterkaskade nach Anspruch 6, **dadurch gekennzeichnet, dass** die Anzahl der Koppelwandler (211;231 bzw. 311;331) jedes transversal gekoppelten Resonatorfilters (2;3) zwei beträgt.

8. Resonatorfilterkaskade nach Anspruch 2, **dadurch gekennzeichnet, dass** die Summe der Aperturen beider Koppelwandlergruppen (211;231 bzw. 311;331) pro transversal gekoppeltem Resonatorfilter (2;3) größer ist als die Hälfte der Summe der Aperturen aller Wandler (211;221;231 bzw. 311;321;331) des betreffenden transversal gekoppelten Resonatorfilters (2 bzw. 3), wobei nur ein Aperturwert pro Koppelwandlergruppe in dieser Summe berücksichtigt wird.

9. Resonatorfilterkaskade nach Anspruch 8, **dadurch gekennzeichnet, dass** bei jedem transversal gekoppelten Resonatorfilter (2;3) eine der Koppelwandlergruppen (231 bzw. 331) unterhalb und die jeweils andere Koppelwandlergruppe (211 bzw. 311) oberhalb der senkrecht zu den Zinken verlaufenden Mittellinie des Reflektorstreifen- /Wandlerzinkengebietes angeordnet ist.

10. Resonatorfilterkaskade nach Anspruch 5, **dadurch gekennzeichnet, dass** die Zinkenüberlappungslängen in den Koppelwandlergruppen so gewählt sind, dass sie eine Funktion bilden, die in Bezug auf die parallel zu der Zinkenrichtung verlaufenden Mittellinie der Resonatorstrukturen unsymmetrisch ist.

11. Resonatorfilterkaskade nach Anspruch 1, **dadurch gekennzeichnet, dass** eine solche Resonatorfilterkaskade Teil einer Kaskadenkette ist, wobei mindestens der Eingang (6) oder Ausgang (7) dieser Resonatorfilterkaskade mit dem Ausgang der vorangegangenen bzw. mit dem Eingang der nachfolgenden Resonatorfilterkaskade durch ein Paar elektrisch leitender Verbindungen verbunden ist.

12. Resonatorfilterkaskade nach Anspruch 1, **dadurch gekennzeichnet, dass** die Anzahl der transversal gekoppelten Resonatorfilter pro Resonatorfilterkaskade zwei beträgt.

13. Resonatorfilterkaskade nach Anspruch 1, **dadurch gekennzeichnet, dass** jeweils eine Komponente aller Paare elektrisch leitender Verbindungen eine gemeinsame Verbindung bilden, wenn diese Komponenten auf gleichem Potenzial liegen.

14. Resonatorfilterkaskade nach Anspruch 7, **dadurch gekennzeichnet, dass** zwischen zwei elektrisch leitende Verbindungen (4;5), die Koppelwandler (211;311 bzw. 231;331) von verschiedenen transversal gekoppelten Resonatorfiltern (2;3) miteinander verbinden, ein Blindwiderstand geschaltet ist, falls das Potenzial dieser elektrisch leitenden Verbindungen (4;5) voneinander verschieden ist.

15. Resonatorfilterkaskade nach Anspruch 1, **dadurch gekennzeichnet, dass** in denjenigen Resonatorstrukturen (22;32), deren Wandler (221;321) den Eingang (6) oder Ausgang (7) der Resonatorfilterkaskade bilden, die Wandler parallel oder in Reihe geschaltet sind, falls die betreffenden Resonatorstrukturen (22;32) jeweils mehr als einen Wandler enthalten.
